(19) Europäisches Patentamt
European Patent Office
Office européen des brevets

(11) **EP 2 629 325 B1**

(12) **EUROPÄISCHE PATENTSCHRIFT**

(45) Veröffentlichungstag und Bekanntmachung des Hinweises auf die Patenterteilung:
**22.10.2014 Patentblatt 2014/43**

(51) Int Cl.:
*H01L 21/68* *(2006.01)*      *H01L 21/67* *(2006.01)*
*G01B 11/00* *(2006.01)*

(21) Anmeldenummer: **13153251.7**

(22) Anmeldetag: **30.01.2013**

(54) **Anordnung und Verfahren zur Positionierung eines Bearbeitungswerkzeuges gegenüber einem Werkstück**

Assembly and method for positioning a machining tool relative to a workpiece

Appareil et procédé destinés à positionner un outil de traitement vis-à-vis d'une pièce à usiner

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **17.02.2012 DE 102012202443**

(43) Veröffentlichungstag der Anmeldung:
**21.08.2013 Patentblatt 2013/34**

(73) Patentinhaber: **Dr. Johannes Heidenhain GmbH 83301 Traunreut (DE)**

(72) Erfinder:
• **Holzapfel, Wolfgang, Dr. 83119 Obing (DE)**
• **Drescher, Jörg, Dr. 83122 Samerberg (DE)**
• **Meissner, Markus, Dr. 83236 Übersee (DE)**
• **Joerger, Ralph, Dr. 83278 Traunstein (DE)**
• **Musch, Bernhard, Dr. 83624 Otterfing (DE)**
• **Kälberer, Thomas 86529 Schrobenhausen (DE)**

(56) Entgegenhaltungen:
DE-A1-102007 023 300      US-A1- 2010 139 836
US-A1- 2010 220 183

**Beschreibung**

Die vorliegende Erfindung betrifft eine Anordnung und ein Verfahren zur Positionierung eines Bearbeitungswerkzeuges gegenüber einem Werkstück.

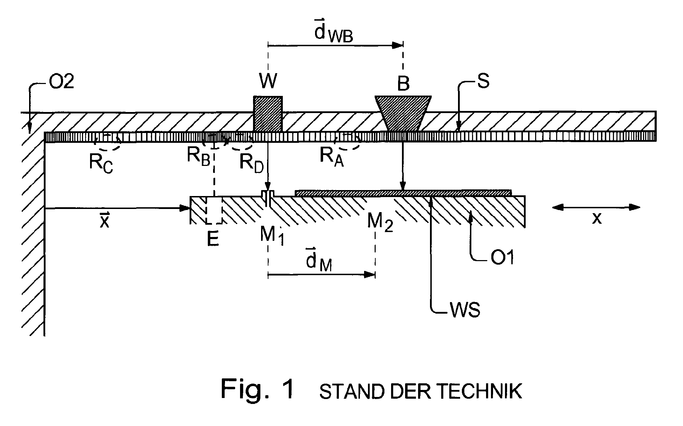

In Maschinen, die bei der Fertigung und/oder Prüfung von Halbleiterbauelementen zum Einsatz kommen, besteht oftmals die Anforderung, ein Bearbeitungswerkzeug gegenüber einem Werkstück präzise zu positionieren. So kann es etwa erforderlich sein, ein Werkstück in Form eines Wafers hochgenau unterhalb eines Werkzeugs zu positionieren. Eine entsprechende Anordnung ist in Figur 1 in stark schematisierter Form dargestellt. Der Wafer bzw. das Werkstück WS ist hierbei auf einem ersten Objekt 01 der Maschine, nämlich einem Tisch, angeordnet. Am ersten Objekt 01 ist ferner eine Objekt-Ausrichtmarkierung $M_1$ vorgesehen; diese kann z.B. als kreisförmige Vertiefung im Tisch oder als lithographisch hergestellte Mikrostruktur auf einer am Tisch befestigten Platte ausgebildet sein. Auf dem am ersten Objekt 01 platzierten Werkstück WS, respektive Wafer, ist zudem eine Werkstück-Ausrichtmarkierung $M_2$ angeordnet, beispielsweise ausgebildet als lokal begrenzte Mikrostruktur.

Gegenüber dem ersten Objekt 01 relativ in mindestens einer Bewegungsrichtung x beweglich ist in der Maschine ein zweites Objekt 02, d.h. ein entsprechendes Maschinenteil, vorgesehen. Die Relativbeweglichkeit zwischen den beiden Objekten 01, 02 kann etwa derart sichergestellt sein, dass das Objekt 01, im vorliegenden Beispiel der Tisch, mindestens entlang der Bewegungsrichtung x beweglich angeordnet ist; das zweite Objekt 02 ist demgegenüber stationär angeordnet.

Am zweiten Objekt 02 ist ein Bearbeitungswerkzeug B sowie ein Ausrichtsensor W vorgesehen. Über das Bearbeitungswerkzeug B ist eine Bearbeitung oder Inspektion des Werkstücks während des Fertigungsprozesses möglich.

Der Ausrichtsensor W ist z.B. als Mikroskop oder Kamera mit elektronischem Bildsensor ausgebildet. Über den Ausrichtsensor W ist es möglich, sowohl die Objekt-Ausrichtmarkierung $M_1$ als auch die Werkstück-Ausrichtmarkierung $M_2$ zu detektieren. Das heißt, dass im Fall der Übereinstimmung der Position des Ausrichtsensors W entlang der Bewegungsrichtung x mit der Position der Objekt-Ausrichtmarkierung $M_1$ bzw. der Werkstück-Ausrichtmarkierung $M_2$ ist ein entsprechendes Ausrichtsignal über den Ausrichtsensor W erzeugbar. Das Ausrichtsignal kann dann zur Weiterverarbeitung an eine nachgeordnete - in Figur 1 nicht dargestellte - Steuereinheit übertragen werden.

Über eine zusätzliche, in Figur 1 nicht dargestellte Sensorik ist ferner ein weiteres Ausrichtsignal erzeugbar, wenn die Position des Bearbeitungswerkzeugs B entlang der Bewegungsrichtung x mit der Position der Objekt-Ausrichtmarkierung $M_1$ übereinstimmt. Dies kann beispielsweise dergestalt erfolgen, dass auf Seiten der Objekt-Ausrichtmarkierung $M_1$ ebenfalls ein Mikroskop oder eine Kamera mit elektronischem Bildsensor angeordnet ist. Falls das Bearbeitungswerkzeugt B Strahlen aussendet, können als Sensorik entsprechende Strahlungsdetektoren verwendet werden, die die von der Objekt- Ausrichtmarkierung $M_1$ reflektierten, transmittierten oder gestreuten Strahlen detektieren. Umgekehrt könnte auch die Objekt-Ausrichtmarkierung $M_1$ Strahlen aussenden, die durch Strahlungsdetektoren im Bearbeitungswerkzeug B detektiert werden können. Alternativ hierzu könnte zur Erzeugung eines derartigen Ausrichtsignals auch ein mechanischer Kontakt zwischen dem Bearbeitungswerkzeug B und der Objekt-Ausrichtmarkierung $M_1$ durch einen elektrischen Kontaktstrom oder geeignete Kraftsensoren detektiert werden.

Zur Bestimmung der Relativposition zwischen dem ersten Objekt 01 und dem zweiten Objekt 02 ist am zweiten Objekt 02 eine beispielsweise optisch abtastbare Maßverkörperung S vorgesehen, die sich entlang der mindestens einen Bewegungsrichtung x erstreckt. Diese Maßverkörperung S kann hierbei etwa als bekanntes Auflicht-Beugungsgitter ausgebildet sein. Auf Seiten des ersten Objekts 01 ist zur Abtastung der Maßverkörperung S eine Abtasteinheit E einer optischen Positionsmesseinrichtung angeordnet. Die Abtasteinheit E kann z.B. eine Lichtquelle, mehrere optische Elemente und eine Detektoranordnung umfassen, um darüber in bekannter Art und Weise, etwa über ein interferentielles Abtastprinzip, hochgenaue Positionssignale bzgl. der Relativposition des ersten und zweiten Objekts 01, 02 für die nachgeordnete Steuereinheit zu erzeugen.

Während der Werkstückbearbeitung durch das Bearbeitungswerkzeug B ist es nunmehr erforderlich, die Position des Bearbeitungswerkzeugs B relativ zur Werkstück-Ausrichtmarkierung $M_2$ hochgenau zu bestimmen. Da keine Positionssignale zum direkten Ausrichten des Bearbeitungswerkzeugs B zur Werkstück-Ausrichtmarkierung $M_2$ erzeugbar sind, muss diese Bestimmung über eine Folge einzelner Kalibrierschritte erfolgen.

So ist eine Referenzierung des Bearbeitungswerkzeugs B zum ersten Objekt 01 mit Hilfe der Objekt-Ausrichtmarkierung $M_1$ erforderlich. Ferner muss eine Referenzierung des Ausrichtsensors W bezüglich des ersten Objekts 01 mit Hilfe der Objekt-Ausrichtmarkierung $M_1$ erfolgen. Und schließlich ist eine Referenzierung des Ausrichtsensors W bezüglich des Werkstückes WS mittels der Werkstück-Ausrichtmarkierung $M_2$ nötig.

In den verschiedenen Maschinenstellungen dieser Kalibrierschritte sowie während der nachfolgenden eigentlichen Bearbeitung tastet die Abtasteinheit E der optischen Positionsmesseinrichtung Bereiche der Maßverkörperung S ab, die in Figur 1 mit den Bezugszeichen $R_A$, $R_B$, $R_C$ und $R_D$ versehen sind. Wie aus der Darstellung ersichtlich, liegen diese Bereiche entlang der Bewegungsrichtung x auf relativ weit auseinanderliegenden Teilen der abgetasteten Maßverkörperung S. So entspricht etwa der Abstand der Bereiche $R_C$ und $R_D$ grob der Größenordnung des Abstands $d_{WB}$ zwischen dem Bearbeitungswerkzeug B und dem Ausrichtsensor W, da die Bearbeitung des Werkstücks WS in der Nähe der Werkstück-Ausrichtmarkierung $M_2$ mit dem Bearbeitungswerkzeug B erfolgt. Das Bearbeitungswerkzeug B befindet sich aber im Abstand $\vec{d}_{WB}$ vom Ausrichtsensor W, mit dem die Werkstück-Ausrichtmarkierung $M_2$ im oben erwähnten dritten Schritt erfasst werden kann. Bei der Positionierung des Bearbeitungswerkzeugs B muss demzufolge mit Messfehlern gerechnet werden, die sich aus der Deformation von Maßverkörperungs-Abschnitten der ungefähren Länge $\vec{d}_{WB}$ ergeben.

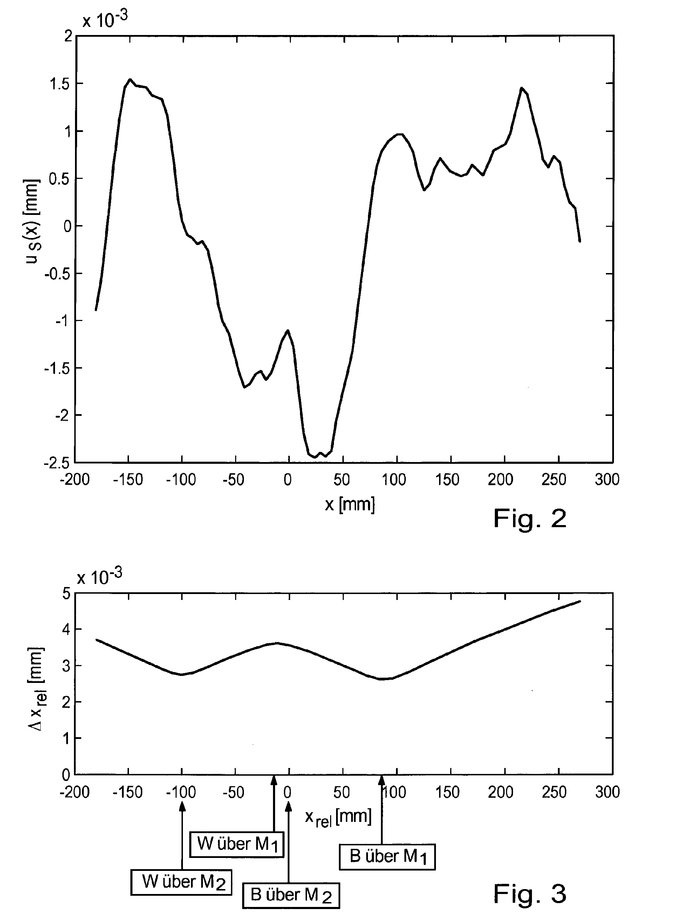

Figur 2 zeigt eine beispielhafte Darstellung zu vorhandenen langwelligen Deformationen einer verwendeten Maßverkörperung S. Ähnliche Abweichungen entstehen desweiteren auch durch Fehler der Maschinenführungen, wenn die Maßverkörperung S nicht fluchtend mit dem Bearbeitungswerkzeug B angeordnet wird (Abbé-Fehler). In Figur 3 sind die bei Verwendung einer solchen Maßverkörperung S resultierenden Positionierungsfehler bzw. die Messunsicherheit $\Delta x_{rel}$ in den verschiedenen Maschinenpositionen gemäß dem oben erläuterten Vorgehen veranschaulicht. Wie aus dieser Darstellung ersichtlich, ist die entsprechende Messunsicherheit $\Delta x_{rel}$ in der Umgebung der maßgeblichen Position $x_{rel} = 0$ erheblich; $x_{rel}$ bezeichnet hierbei den Abstand der Bearbeitungsposition von der Werkstück-Ausrichtmarkierung $M_2$.

Aus der DE 10 2007 023 300 A1 ist eine Positionsmesseinrichtung bekannt, die zwei gekreuzt angeordnete Maßstäbe und eine zugeordnete Abtasteinheit umfasst. Über die Abtastoptik ist sichergestellt, dass die Lage der sog. neutralen Drehpunkte der beiden Maßstäbe übereinstimmt.

Die Druckschriften US 201010220183 A1 und US 2010/0139836 A1 offenbaren jeweils Anordnungen von Positionsmesseinrichtungen in Maschinen zur Be- und Verarbeitung von elektronischen Bauelementen. Hierbei besitzen die entsprechenden Maschinen völlig andere Geometrien und Kinematiken als die anhand von Figur 1 erläuterte Maschine.

Den genannten Druckschriften sind somit keine Ansätze für die Lösung der eingangs diskutierten Problematik zu entnehmen.

Aufgabe der vorliegenden Erfindung ist es daher, eine Anordnung und ein Verfahren zur Positionierung eines Bearbeitungswerkzeuges gegenüber einem Werkstück anzugeben, über welches eine hochgenaue Positionierung des Bearbeitungswerkzeuges gewährleistet ist und insbesondere Messfehler minimiert bzw. vermieden werden, die aus Fehlern der dabei eingesetzten Maßverkörperung resultieren.

Diese Aufgabe wird erfindungsgemäß durch eine Anordnung mit den Merkmalen des Anspruchs 1 gelöst.

Ferner wird diese Aufgabe erfindungsgemäß durch ein Verfahren mit den Merkmalen des Anspruchs 7 gelöst,

Vorteilhafte Ausführungen der erfindungsgemäßen Anordnung und des erfindungsgemäßen Verfahrens ergeben sich aus den Maßnahmen In den jeweiligen abhängigen Ansprüchen.

Die erfindungsgemäße Anordnung zur Positionierung eines Bearbeitungswerkzeuges gegenüber einem Werkstück umfasst ein erstes Objekt, auf dem eine Objekt-Ausrichtmarkierung und das Werkstück angeordnet sind, wobei auf dem Werkstück eine Werkstück-Ausrichtmarkierung angeordnet ist. Ferner umfasst die Anordnung ein zweites Objekt, welches gegenüber dem ersten Objekt entlang mindestens einer Bewegungsrichtung beweglich angeordnet ist. Am zweiten Objekt ist das Bearbeitungswerkzeug angeordnet, über das die Objekt-Ausrichtmarkierung detektierbar ist. Ferner ist daran ein Ausrichtsensor angeordnet, über den die Objekt-Ausrichtmarkierung und die Werkstück-Ausrichtmarkierung detektierbar sind. Desweiteren ist am zweiten Objekt eine abtastbare Maßverkörperung angeordnet, die sich entlang der mindestens einen Bewegungsrichtung erstreckt. Am ersten Objekt sind mindestens zwei Abtasteinheiten zur Abtastung der Maßverkörperung angeordnet, um derart die Relativposition zwischen dem ersten und dem zweiten Objekt entlang der Bewegungsrichtung bestimmen, wobei die beiden Abtasteinheiten einen definierten Versatz aufweisen.

Es ist hierbei möglich, den Versatz zwischen den beiden Abtasteinheiten nahezu identisch zum Abstand zwischen dem Bearbeitungswerkzeug und dem Ausrichtsensor zu wählen.

Ferner kann der Versatz zwischen den beiden Abtasteinheiten identisch zum Abstand zwischen dem Bearbeitungswerkzeug und dem Ausrichtsensor gewählt werden.

Mit Vorteil genügt der Versatz zwischen den beiden Abtasteinheiten der Bedingung

$$| \vec{d}_E - \vec{d}_{WB} | < 0.2 \cdot | \vec{d}_{WB} |,$$

mit

$\vec{d}_E :=$ Versatz zwischen den beiden Abtasteinheiten,

$\vec{d}_{WB}$:= Abstand zwischen dem Bearbeitungswerkzeug und dem Ausrichtsensor.

Es kann vorgesehen werden, dass zur Bestimmung der Relativposition zwischen dem ersten und dem zweiten Objekt entlang der Bewegungsrichtung die Abtasteinheiten selektiv aktivierbar ausgebildet sind.

Die Objekt-Ausrichtmarkierung und/oder die Werkstück-Ausrichtmarkierung kann als Mikrostruktur ausgebildet sein.

Es ist möglich, dass die Maßverkörperung als Linearteilung oder als Winkelteilung oder als zweidimensionale Kreuzgitterteilung ausgebildet ist.

Im Rahmen des erfindungsgemäßen Verfahrens zur Positionierung eines Bearbeitungswerkzeuges gegenüber einem Werkstück ist vorgesehen, dass auf einem ersten Objekt eine Objekt-Ausrichtmarkierung und das Werkstück angeordnet sind und auf dem Werkstück eine Werkstück-Ausrichtmarkierung angeordnet ist. Ein zweites Objekt ist gegenüber dem ersten Objekt entlang mindestens einer Bewegungsrichtung beweglich angeordnet ist. Am zweiten Objekt ist ein Bearbeitungswerkzeug angeordnet, über das die Objekt-Ausrichtmarkierung detektiert wird. Ferner ist daran ein Ausrichtsensor angeordnet, über den die Objekt-Ausrichtmarkierung und die Werkstück-Ausrichtmarkierung detektiert wird. Desweiteren ist am zweiten Objekt eine abtastbare Maßverkörperung angeordnet, die sich entlang der mindestens einen Bewegungsrichtung erstreckt. Am ersten Objekt sind mindestens zwei Abtasteinheiten zur Abtastung der Maßverkörperung angeordnet, über die die Relativposition zwischen dem ersten und dem zweiten Objekt entlang der Bewegungsrichtung bestimmt wird und wobei die beiden Abtasteinheiten einen definierten Versatz aufweisen.

Es ist hierbei möglich, dass der Versatz zwischen den beiden Abtasteinheiten nahezu identisch zum Abstand zwischen dem Bearbeitungswerkzeug und dem Ausrichtsensor gewählt wird.

Ferner kann vorgesehen werden, dass der Versatz zwischen den beiden Abtasteinheiten identisch zum Abstand zwischen dem Bearbeitungswerkzeug und dem Ausrichtsensor gewählt wird.

In einer vorteilhaften Ausführungsform wird der Versatz zwischen den beiden Abtasteinheiten gemäß der Bedingung

$$| \vec{d}_E - \vec{d}_{WB} | < 0.2 \cdot | \vec{d}_{WB} |$$

mit

$\vec{d}_E$ := Versatz zwischen den beiden Abtasteinheiten,

$\vec{d}_{WB}$ := Abstand zwischen dem Bearbeitungswerkzeug und dem Ausrichtsensor.

Es kann vorgesehen werden, dass zur Bestimmung der Relativposition zwischen dem ersten und dem zweiten Objekt wahlweise nur eine der beiden Abtasteinheiten aktiviert wird.

In einer Variante des erfindungsgemäßen Verfahrens wird in einem Verfahrensschritt die Objekt-Ausrichtmarkierung mit dem Bearbeitungswerkzeug angefahren und die dabei mittels einer ersten Abtasteinheit erfasste Relativposition zwischen dem ersten und zweiten Objekt registriert. In einem weiteren Verfahrensschritt wird die Objekt-Ausrichtmarkierung mit dem Ausrichtsensor angefahren und die dabei mittels einer zweiten Abtasteinheit erfasste Relativposition zwischen dem ersten und zweiten Objekt registriert; In einem weiteren Verfahrensschritt wird die Werkstück-Ausrichtmarkierung mit dem Ausrichtsensor angefahren und die dabei mittels der zweiten Abtasteinheit erfasste Relativposition zwischen dem ersten und zweiten Objekt registriert. Die Reihenfolge der drei verschiedenen Verfahrensschritte ist beliebig wählbar.

In dieser Variante des erfindungsgemäßen Verfahrens wird anschließend auf Grundlage der Messungen der vorhergehenden drei Verfahrensschritte die Positionierung des ersten Objektes gegenüber dem zweiten Objekt während der Bearbeitung des Werkstückes mit dem Bearbeitungswerkzeug in der Umgebung der Werkstück-Ausrichtmarkierung vorgenommen.

Als besonderer Vorteil der erfindungsgemäßen Lösung ist anzuführen, dass nunmehr zur exakten Positionierung des Bearbeitungswerkzeuges gegenüber dem Werkstück nicht mehr ein relativ großer Bereich der zur Positionsbestimmung genutzten Maßverkörperung abgetastet werden muss. Die Abtastung durch die erfindungsgemäß mindestens zwei Abtasteinheiten beschränkt sich demgegenüber auf kleine, räumlich eng begrenzte Bereiche der Maßverkörperung. Es spielen für die Genauigkeit der Positionsbestimmung somit nur die Ungenauigkeiten der Maßverkörperung in diesen räumlich begrenzten Bereichen eine Rolle. Die Ausdehnung dieser Bereiche hängt hierbei i.w. von der bearbeiteten Werkstückfläche ab. Insgesamt resultieren somit deutlich geringere Fehler bei der Positionsbestimmung und der darauf basierenden Relativpositionierung von Bearbeitungswerkzeug und Werkstück.

Eine aufwändige Kalibrierung der verwendeten Maßverkörperung kann damit je nach Genauigkeitsanforderungen entfallen. Außerdem kann die thermische Stabilisierung der jeweiligen Maschine einfacher ausgelegt werden, da die durch die thermische Ausdehnung verursachten Messfehler innerhalb der kleinen Abmessungen der abgetasteten Bereiche der Maßverkörperung vernachlässigbar sind. Die thermische Ausdehnung zwischen den abgetasteten Bereichen spielt aufgrund der erfindungsgemäßen Nutzung der mindestens zwei beabstandeten Abtasteinheiten in den verschiedenen Verfahrensschritten keine Rolle mehr.

Weitere Vorteile sowie Einzelheiten der vorliegenden Erfindung ergeben sich aus der nachfolgenden Beschreibung von Ausführungsbeispielen anhand der beiliegenden Figuren.

Es zeigt hierbei

Figur 1    eine erste schematisierte Darstellung zur Erläuterung des Standes der Technik;

Figur 2    eine beispielhafte Darstellung zu den vorhandenen langwelligen Deformationen einer Maßverkörperung;

Figur 3    eine Darstellung der resultierenden Positionierungsfehler an den verschiedenen Positionen bei einem Vorgehen gemäß dem Stand der Technik;

Figur 4 - 7    jeweils einen Verfahrensschritt unter Verwendung der erfindungsgemäßen Anordnung;

Figur 8    eine Darstellung der resultierenden Positionierungsfehler an den verschiedenen Positionen bei einem Vorgehen unter Verwendung der erfindungsgemäßen Anordnung.

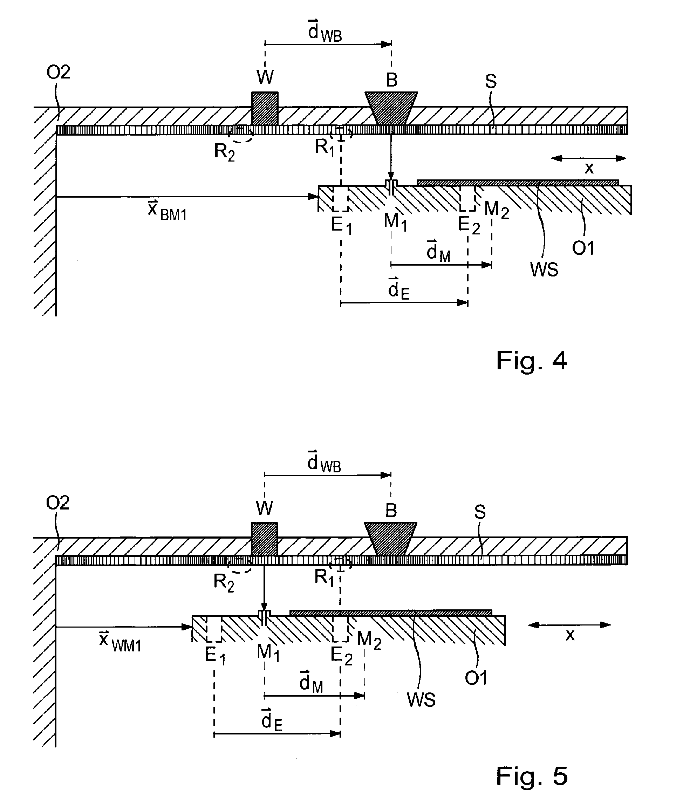

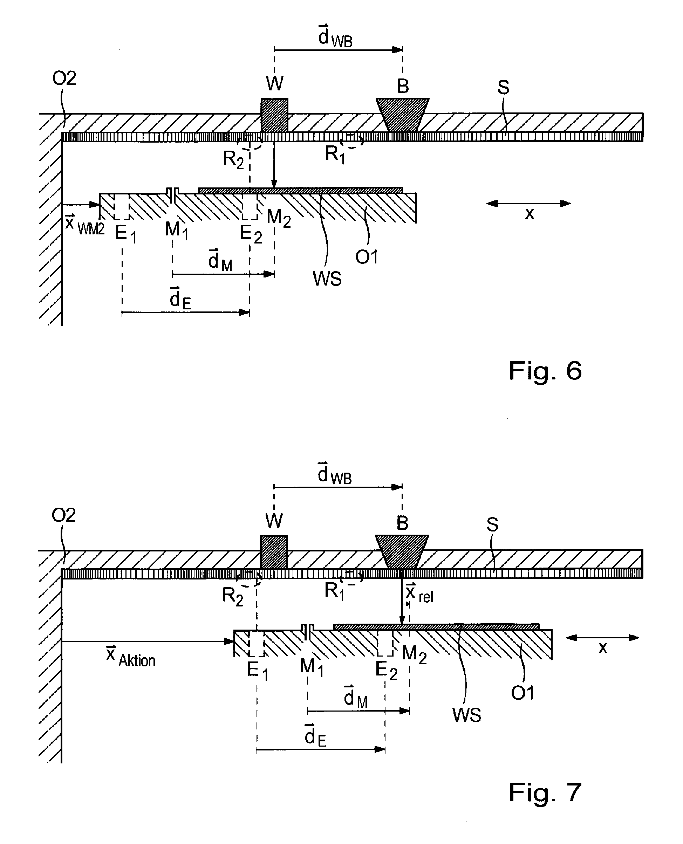

In den Figuren 4 - 6 ist die erfindungsgemäße Anordnung in den eingangs erwähnten unterschiedlichen Kalibrier- bzw. Referenzierschritten gezeigt, die vor der eigentlichen Bearbeitungsphase zu Kalibrierungszwecken durchlaufen werden. Figur 7 zeigt diejenige Phase, in der die eigentliche Werkstückbearbeitung erfolgt. Soweit nicht nachfolgend explizit eine andere Bedeutung der verschiedenen Bezugszeichen erwähnt ist, entsprechen diese den Bezugszeichen aus der eingangs beschriebenen Figur 1. Anhand der Figuren 4 - 7 sei nachfolgend ein Ausführungsbeispiel der erfindungsgemäßen Anordnung sowie des erfindungsgemäßen Verfahrens erläutert.

Die grundlegende Idee der vorliegenden Erfindung besteht darin, dass im Unterschied zum eingangs diskutierten Stand der Technik nunmehr am ersten Objekt 01 mindestens zwei Abtasteinheiten $E_1$, $E_2$ zur Abtastung der Maßverkörperung S angeordnet sind, um derart die Relativposition zwischen dem ersten Objekt 01 und dem zweiten Objekt 02 entlang der Bewegungsrichtung x hochgenau zu bestimmen. Im dargestellten Ausführungsbeispiel ist eine hochauflösende optische Abtastung der Maßverkörperung S vorgesehen, etwa über ein interferentielles Abtastprinzip. Die beiden Abtasteinheiten $E_1$, $E_2$ weisen hierbei einen definiert gewählten Versatz $\vec{d}_E$ auf, wie dies aus den Darstellungen der Figuren 4 - 7 ersichtlich ist; im dargestellten Ausführungsbeispiel erstreckt sich' der Versatz $\vec{d}_E$ entlang der Bewegungsrichtung x. Der Versatz $\vec{d}_E$ zwischen den beiden Abtasteinheiten $E_1$, $E_2$ wird erfindungsgemäß nahezu identisch zum Abstand $\vec{d}_{WB}$ zwischen dem Bearbeitungswerkzeug B und dem Ausrichtsensor W gewählt; in einer möglichen Ausführungsform sogar völlig identisch hierzu. Grundsätzlich erweist sich als vorteilhaft für den Versatz $\vec{d}_E$ zwischen den beiden Abtasteinheiten $E_1$, $E_2$ entlang der Bewegungsrichtung x, wenn dieser gemäß der Bedingung

$$| \vec{d}_E - \vec{d}_{WB} | << | \vec{d}_{WB} | \qquad (Gl.\ 1)$$

gewählt wird,
mit

$\vec{d}_E$ := Versatz zwischen den beiden Abtasteinheiten entlang der Bewegungsrichtung,
$\vec{d}_{WB}$ := Abstand zwischen dem Bearbeitungswerkzeug und dem Ausrichtsensor entlang der Bewegungsrichtung.

In einer vorteilhaften Ausführungsform wird etwa

$$| \vec{d}_E - \vec{d}_{WB} | < 0.2 \cdot | \vec{d}_{WB} | \qquad \text{(Gl. 1.1)}$$

gewählt.

Aufgrund der Verwendung der mindestens zwei Abtasteinheiten $E_1$, $E_2$ am ersten Objekt 01 mit definiertem Versatz $\vec{d}_E$ lassen sich die eingangs erläuterten Messfehler bei der Positionsbestimmung aufgrund eventuell vorliegender Deformationen der abgetasteten Maßverkörperung S stark verringern, wie nachfolgend anhand der Beschreibung der Figuren 4 - 8 im Detail veranschaulicht wird.

Ein erster Kalibrierschritt V1 vor der eigentlichen Werkstückbearbeitung mit Hilfe der erfindungsgemäßen Anordnung ist in Figur 4 dargestellt. Dabei wird die Objekt-Ausrichtmarkierung $M_1$ mit dem Bearbeitungswerkzeug B angefahren, mittels der ersten Abtasteinheit $E_1$ die Relativposition zwischen dem ersten Objekt 01 und dem zweiten Objekt 02 erfasst und von der - nicht dargestellten Steuereinheit - registriert. Wie in Figur 4 durch die strichlinierte Verbindung zwischen der ersten Abtasteinheit $E_1$ und der Maßverkörperung S angedeutet, wird in diesem Schritt zur Positionsbestimmung über die erste Abtasteinheit $E_1$ ein mit $R_1$ bezeichneter erster Bereich der Maßverkörperung S abgetastet.

Ein weiterer Kalibrierschritt V2 ist in Figur 5 dargestellt. Hierbei wird die Objekt-Ausrichtmarkierung M1 mit dem Ausrichtsensor W angefahren, mittels der zweiten Abtasteinheit $E_2$ die Relativposition zwischen dem ersten Objekt 01 und dem zweiten Objekt 02 erfasst und von der Steuereinheit registriert. Die zweite Abtasteinheit $E_2$ tastet in dieser Phase wie ersichtlich auf der Maßverkörperung S ebenfalls den mit $R_1$ bezeichneten ersten Bereich ab, d.h. den gleichen Bereich wie im vorhergehenden Kalibrierschritt.

Der dritte Kalibrierschritt V3 mit Hilfe der erfindungsgemäßen Anordnung ist in Figur 6 dargestellt. Nunmehr wird die Werkstück-Ausrichtmarkierung $M_2$ mit dem Ausrichtsensor W angefahren, mit Hilfe der zweiten Abtasteinheit $E_2$ die Relativposition zwischen dem ersten Objekt 01 und dem zweiten Objekt 02 erfasst und von der Steuereinheit registriert. Über die zweite Abtasteinheit $E_2$ erfolgt wie aus Figur 6 ersichtlich in diesem Verfahrensschritt die Abtastung eines zweiten Bereichs $R_2$ auf der Maßverkörperung S.

Es sei an dieser Stelle darauf hingewiesen, dass diese drei Verfahrensschritte V1 - V3 zu Kalibrierungszwecken vor der eigentlichen Werkstückbearbeitung nicht zwangsläufig in der beschriebenen Reihenfolge erfolgen müssen; es ist vielmehr auch eine andere Reihenfolge dieser Verfahrensschritte möglich.

In Figur 7 ist schließlich die auf die Kalibrierungsschritte V1 - V3 folgende Werkstückbearbeitung veranschaulicht. Hierbei wird über das Bearbeitungswerkzeug B das Werkstück WS in der Nähe der Werkstück-Ausrichtmarkierung $M_2$ bearbeitet. In dieser Phase erfolgt die Positionsbestimmung wie aus der Figur ersichtlich mit Hilfe der ersten Abtasteinheit $E_1$, die nunmehr den zweiten Bereich $R_2$ auf der Maßverkörperung S abtastet.

In den verschiedenen Verfahrensschritten dieses Ausführungsbeispiels ist wird jeweils nur eine der beiden Abtasteinheiten $E_1$, $E_2$ zur Positionsbestimmung genutzt. Das heißt, es ist jeweils nur eine der beiden Abtasteinheiten $E_1$, $E_2$ von der übergeordneten Steuereinheit aktiviert. Die Abtasteinheiten $E_1$, $E_2$ sind demzufolge selektiv aktivierbar ausgebildet.

Wie aus dieser Erläuterung der verschiedenen Verfahrensschritte mit Hilfe der erfindungsgemäßen Anordnung deutlich wird, beschränkt sich die Abtastung der genutzten Maßverkörperung S mit den beiden Abtasteinheiten $E_1$, $E_2$ während der Kalibrierung als auch der eigentlichen Werkstückbearbeitung auf lediglich zwei Bereiche $R_1$, $R_2$ auf der Maßverkörperung S. Diese beiden Bereiche $R_1$, $R_2$ besitzen zudem jeweils nur eine relativ kleine flächige Ausdehnung mit Durchmessern in der Teilungs-Ebene der Maßverkörperung S, die um Größenordnungen kleiner sind als etwa der o.g. Abstand $|d_{WB}|$. Da somit in die Positionsbestimmung während des Bearbeitungsvorgangs gemäß Figur 7 lediglich relative Positionsmessungen eingehen, die aus der Abtastung der beiden Bereiche $R_1$, $R_2$ mit kleiner Ausdehnung stammen, lassen sich die eingangs erwähnten Fehler, verursacht durch eventuelle langwellige Fehler der Maßverkörperung S, stark minimieren. Es resultiert aufgrund der erfindungsgemäßen Maßnahmen eine optimierte Positionsbestimmung im Bearbeitungsprozess.

Nachfolgend sei mit Bezug auf die Figuren 4 - 7 erläutert, wieso aufgrund der erfindungsgemäßen Maßnahmen eine derartige Fehlerminimierung resultiert.

Die Stellung des Objekts 01, d.h. des Tisches, bei der sich das Bearbeitungswerkzeug B über der Werkstück-Ausrichtmarkierung $M_2$ befindet, sei mit $\vec{x}_{BM2}$ bezeichnet. Die Objektpositionen in den drei Kalibrierungs-Verfahrensschritten V1 - V3 sowie im Bearbeitungs-Verfahrensschritt V4 lauten somit:

$$V1: \quad \vec{x}_{BM1} = \vec{x}_{BM2} + \vec{d}_M \qquad \text{(Gl. 2.1)}$$

$$V2: \quad \vec{x}_{WM1} = \vec{x}_{BM2} + \vec{d}_M - \vec{d}_{WB} \qquad (Gl.\ 2.2)$$

$$V3: \quad \vec{x}_{WM2} = \vec{x}_{BM2} - \vec{d}_{WB} \qquad (Gl.\ 2.3)$$

$$V4: \quad \vec{x}_{Aktion} = \vec{x}_{BM2} + \vec{x}_{rel} \qquad (Gl.\ 2.4)$$

Hierbei ist $\vec{x}_{rel}$ die gesuchte Größe, nämlich der Versatz des Bearbeitungswerkzeuges B relativ zur Werkstück-Ausrichtmarkierung $M_2$ während der Bearbeitung in der Tischposition $\vec{x}_{Aktion}$. Der Einfachheit halber sei nachfolgend ein System aus Maßverkörperung S und Abtasteinheiten $E_1$, $E_2$ betrachtet, mit dem nur eine einzige Komponente von $\vec{x}_{rel}$ entlang einer Messrichtung $\vec{a}$ bestimmt werden kann, In der Praxis können mehrere Komponenten von $\vec{x}_{rel}$ bestimmt werden, indem Systeme aus Abtasteinheiten $E_1$, $E_2$ und Maßverkörperungen S miteinander kombiniert werden, die unterschiedliche Messrichtungen aufweisen.

Der ausgegebene Messwert $m_{E1}$ der Abtasteinheit $E_1$ beim Ablesen der Maßverkörperung S an einer bestimmten Stelle $\vec{x}$ wird beschrieben als Funktion

$$m_{E1}(\vec{x}) := \vec{x} \cdot \vec{a} + u_S(\vec{x}), \qquad (Gl.\ 2.5)$$

wobei $u_s(\vec{x})$ ein langsam mit $\vec{x}$ veränderlicher Fehlerterm ist, der von einer ungleichmäßigen bzw. deformierten Maßverkörperung S herrührt.

Der von der Abtasteinheit $E_2$ erfasste Messwert $m_{E2}(\vec{x})$ wird entsprechend als Funktion

$$m_{E2}(\vec{x}) := (\vec{x} + \vec{d}_E) \cdot \vec{a} + u_S(\vec{x} + \vec{d}_E), \qquad (Gl.\ 2.6)$$

dargestellt.

Die in den vier Maschinenstellungen abgegriffenen Messwerte $m_1$ - $m_4$ ergeben sich dann folgendermaßen:

$$m_1 = m_{E1}(\vec{x}_{BM1}) = (\vec{x}_{BM2} + \vec{d}_M) \cdot \vec{a} + u_S(\vec{x}_{BM2} + \vec{d}_M) \qquad (Gl.\ 2.7)$$

$$m_2 = m_{E2}(\vec{x}_{WM1}) = (\vec{x}_{BM2} + \vec{d}_M - \vec{d}_{WB} + \vec{d}_E) \cdot \vec{a} + u_S(\vec{x}_{BM2} + \vec{d}_M - \vec{d}_{WB} + \vec{d}_E)$$

$$(Gl.\ 2.8)$$

$$m_3 = m_{E2}(\vec{x}_{WM2}) = (\vec{x}_{BM2} - \vec{d}_{WB} + \vec{d}_E) \cdot \vec{a} + u_S(\vec{x}_{BM2} - \vec{d}_{WB} + \vec{d}_E) \qquad (Gl.\ 2.9)$$

$$m_4 = m_{E1}(\vec{x}_{Aktion}) = (\vec{x}_{BM2} + \vec{x}_{rel}) \cdot \vec{a} + u_S(\vec{x}_{BM2} + \vec{x}_{rel}) \qquad \text{(Gl. 2.10)}$$

Die gesuchte Größe $\vec{x}_{rel} \cdot \vec{a}$ erhält man bis auf die unbekannten Fehlerterme $u_s$ aus einer geeigneten Linearkombination der Messwerte $m_1$ bis $m_4$ :

$$\begin{aligned}
-m_1 + m_2 - m_3 + m_4 \qquad &= \vec{x}_{rel} \cdot \vec{a} \\
&- u_S(\vec{x}_{BM2} + \vec{d}_M) + u_S(\vec{x}_{BM2} + \vec{d}_M + \overline{\delta d}) \\
&- u_S(\vec{x}_{BM2} + \overline{\delta d}) + u_S(\vec{x}_{BM2} + \vec{x}_{rel}), \qquad \text{(Gl. 2.11)}
\end{aligned}$$

wobei $\overline{\delta d} := \vec{d}_E - \vec{d}_{WB}$ eingeführt wurde.

Es sei nun vorausgesetzt, das $\overline{\delta d}$ und $\vec{x}_{rel}$ klein sind gegenüber der Größenordnung von Verschiebungen, ab der signifikante Veränderungen von $u_s(\vec{x})$ zu erwarten sind. Unter dieser Voraussetzung löschen sich die Fehlerterme jeweils in der zweiten und dritten Zeile der Gl. 2.12 größtenteils aus, da Maßverkörperungsfehler an jeweils fast der gleichen Position der Maßverkörperung S mit unterschiedlichem Vorzeichen entstehen. Dies gilt unabhängig von der Messrichtung $\vec{a}$ und damit für alle zu messenden Freiheitsgrade der Relativbewegung der beiden Objekte O1, O2.

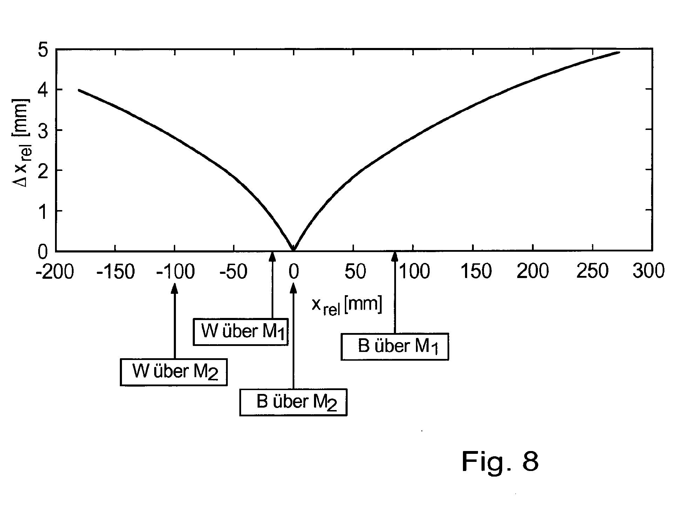

Wie aus dieser Betrachtung deutlich wird, spielt die Ungenauigkeit der Maßverkörperung S aufgrund der erfindungsgemäßen Maßnahmen letztlich nur noch innerhalb relativ kleiner, räumlich begrenzter Bereiche $R_1$, $R_2$ eine Rolle. Die Größe dieser Bereiche $R_1$, $R_2$ ist i.w. durch die zu bearbeitende Werkstückfläche um die Werkstück-Ausrichtmarkierung $M_2$ herum gegeben. Unter Annahme einer vorliegenden Deformation der Maßverkörperung gemäß Figur 2 zeigt Figur 8 analog zur Darstellung von Figur 3 die resultierenden Positionierungsfehler bzw. die Messunsicherheit $\Delta x_{rel}$ in den verschiedenen Maschinenpositionen, wenn nunmehr erfindungsgemäß mindestens zwei Abtasteinheiten wie erläutert verwendet werden. Wie aus Figur 8 ersichtlich, geht jetzt die von der Maßverkörperungsdeformation her resultierende Messungenauigkeit $\Delta x_{rel}$ bei $\vec{x}_{rel}$ = 0 auf Null zurück. Eine Positionierung des Bearbeitungswerkzeugs B ist in der Umgebung der Werkstück-Ausrichtmarkierung $M_2$ nunmehr mit hoher Genauigkeit möglich.

Neben dem erläuterten Ausführungsbeispiel der erfindungsgemäßen Anordnung und dem erfindungsgemäßen Verfahren gibt es selbstverständlich im Rahmen der vorliegenden Erfindung noch weitere Ausgestaltungsmöglichkeiten.

So kann alternativ zu einer linearen Maßverkörperung auch vorgesehen werden, eine zweidimensionale Maßverkörperung, ausgebildet als Kreuzgitterteilung, einzusetzen. Desweiteren ist es möglich, im Fall der Verdrehbarkeit der Objekte zueinander, die Maßverkörperung als Winkelteilung auszubilden, die dann von zwei beabstandeten Abtasteinheiten abgetastet wird. Erfindungsgemäß muss in diesem Fall der Winkelabstand der beiden Abtasteinheiten etwa dem Winkelabstand zwischen der Objekt-Ausrichtmarkierung und der Werkstück-Ausrichtmarkierung entsprechen.

Alternativ zu einer optischen Abtastung der Maßverkörperung kann ferner auch eine magnetische, kapazitive oder induktive Abtastung mit einer entsprechenden Ausbildung der Maßverkörperung und der Abtasteinheiten vorgesehen werden.

Desweiteren können auch mehrere Bearbeitungswerkzeuge und/oder Ausrichtsensoren in der erfindungsgemäßen Anordnung vorhanden sein. In diesem Fall wären auch entsprechend mehr Abtasteinheiten erforderlich. Für die einzelnen Verfahrensschritte sind dann jeweils die geeigneten Abtasteinheiten analog zum oben beschriebenen Vorgehen auszuwählen.

In einer Variante bzw. Fortbildung des erfindungsgemäßen Verfahrens wäre es ferner möglich, vor den oben erläuterten Kalibrierungsschritten einen zusätzlichen Messdurchgang entlang des Messbereichs mit zwei aktiven Abtasteinheiten durchzuführen; die hierbei erzeugten Messwerte der beiden Abtasteinheiten werden dabei in Differenz zueinander gesetzt. In den nachfolgenden, oben erläuterten Verfahrensschritten können die dabei resultierenden Messwerte mit den im vorhergehenden Messdurchgang gewonnenen Kalibrierungsdaten verrechnet werden.

**Patentansprüche**

1. Anordnung zur Positionierung eines Bearbeitungswerkzeuges (B) gegenüber einem Werkstück (WS) mit

- einem ersten Objekt (O1), auf dem eine Objekt-Ausrichtmarkierung ($M_1$) und das Werkstück (WS) angeordnet sind, wobei auf dem Werkstück (WS) eine Werkstück-Ausrichtmarkierung ($M_2$) angeordnet ist und
- einem zweiten Objekt (02), welches gegenüber dem ersten Objekt (O1) entlang mindestens einer Bewegungsrichtung (x) beweglich angeordnet ist, wobei am zweiten Objekt (02)

    - das Bearbeitungswerkzeug (B) angeordnet ist, über das die Objekt-Ausrichtmarkierung ($M_1$) detektierbar ist, und
    - ein Ausrichtsensor (W) angeordnet ist, über den die Objekt-Ausrichtmarkierung ($M_1$) und die Werkstück-Ausrichtmarkierung ($M_2$) detektierbar sind, und
    - eine abtastbare Maßverkörperung (S) angeordnet ist, die sich entlang der mindestens einen Bewegungsrichtung (x) erstreckt,

**dadurch gekennzeichnet, dass**

- am ersten Objekt (01) mindestens zwei Abtasteinheiten ($E_1$, $E_2$) zur Abtastung der Maßverkörperung (S) angeordnet sind, um derart die Relativposition zwischen dem ersten und dem zweiten Objekt (O1, 02) entlang der Bewegungsrichtung (x) zu bestimmen und wobei die beiden Abtasteinheiten ($E_1$, $E_2$) einen definierten Versatz ($\vec{d}_E$) aufweisen und
- wobei der Versatz ($\vec{d}_E$) zwischen den beiden Abtasteinheiten ($E_1$, $E_2$) der Bedingung

$$| \vec{d}_E - \vec{d}_{WB} | < 0.2 \cdot | \vec{d}_{WB} |$$

genügt,
mit

    $\vec{d}_E$ := Versatz zwischen den beiden Abtasteinheiten,
    $\vec{d}_{WB}$ := Abstand zwischen dem Bearbeitungswerkzeug und dem Ausrichtsensor.

2. Anordnung nach Anspruch 1, **dadurch gekennzeichnet, dass** der Versatz ($\vec{d}_E$) zwischen den beiden Abtasteinheiten ($E_1$, $E_2$) nahezu identisch zum Abstand ($\vec{d}_{WB}$) zwischen dem Bearbeitungswerkzeug (B) und dem Ausrichtsensor (W) gewählt ist.

3. Anordnung nach Anspruch 1, **dadurch gekennzeichnet, dass** der Versatz ($\vec{d}_E$) zwischen den beiden Abtasteinheiten ($E_1$, $E_2$) identisch zum Abstand ($\vec{d}_{WB}$) zwischen dem Bearbeitungswerkzeug (B) und dem Ausrichtsensor (W) gewählt ist.

4. Anordnung nach mindestens einem der vorhergehenden Ansprüche, **dadurch gekennzeichnet, dass** zur Bestimmung der Relativposition zwischen dem ersten und dem zweiten Objekt (O1, O2) entlang der Bewegungsrichtung (x) die Abtasteinheiten (E1, E2) selektiv aktivierbar ausgebildet sind.

5. Anordnung nach Anspruch 1, **dadurch gekennzeichnet, dass** die Objekt-Ausrichtmarkierung ($M_1$) und/oder Werkstück-Ausrichtmarkierung ($M_2$) als Mikrostruktur ausgebildet ist.

6. Anordnung nach Anspruch 1, **dadurch gekennzeichnet, dass** die Maßverkörperung als Linearteilung oder als Winkelteilung oder als zweidimensionale Kreuzgitterteilung ausgebildet ist.

7. Verfahren zur Positionierung eines Bearbeitungswerkzeuges (B) gegenüber einem Werkstück (WS), bei dem

- auf einem ersten Objekt (O1) eine Objekt-Ausrichtmarkierung ($M_1$) und das Werkstück (WS) angeordnet sind und auf dem Werkstück (WS) eine Werkstück-Ausrichtmarkierung ($M_2$) angeordnet ist und
- ein zweites Objekt (O2) gegenüber dem ersten Objekt (01) entlang mindestens einer Bewegungsrichtung (x) beweglich angeordnet ist, wobei am zweiten Objekt (02)

    - das Bearbeitungswerkzeug (B) angeordnet ist, über das die Objekt-Ausrichtmarkierung ($M_1$) detektiert

wird und

- ein Ausrichtsensor (W) angeordnet ist, über den die Objekt-Ausrichtmarkierung ($M_1$) und die Werkstück-Ausrichtmarkierung ($M_2$) detektiert wird und
- eine abtastbare Maßverkörperung (S) angeordnet ist, die sich entlang der mindestens einen Bewegungsrichtung (x) erstreckt,

**dadurch gekennzeichnet, dass**

- am ersten Objekt (01) mindestens zwei Abtasteinheiten ($E_1$, $E_2$) zur Abtastung der Maßverkörperung (S) angeordnet sind, über die die Relativposition zwischen dem ersten und dem zweiten Objekt (O1, O2) entlang der Bewegungsrichtung (x) bestimmt wird und wobei die beiden Abtasteinheiten ($E_1$, $E_2$) einen definierten Versatz ($\vec{d}_E$) aufweisen und
- wobei der Versatz ($\vec{d}_E$) zwischen den beiden Abtasteinheiten ($E_1$, $E_2$) gemäß der Bedingung

$$|\vec{d}_E - \vec{d}_{WB}| < 0.2 \cdot |\vec{d}_{WB}|$$

gewählt wird,
mit

$\vec{d}_E$ := Versatz zwischen den beiden Abtasteinheiten,
$\vec{d}_{WB}$ := Abstand zwischen dem Bearbeitungswerkzeug und dem Ausrichtsensor.

8. Verfahren nach Anspruch 7, **dadurch gekennzeichnet, dass** der Versatz ($\vec{d}_E$) zwischen den beiden Abtasteinheiten ($E_1$, $E_2$) nahezu identisch zum Abstand ($\vec{d}_{WB}$) zwischen dem Bearbeitungswerkzeug (B) und dem Ausrichtsensor (W) gewählt wird.

9. Verfahren nach Anspruch 7, **dadurch gekennzeichnet, dass** der Versatz ($\vec{d}_E$) zwischen den beiden Abtasteinheiten ($E_1$, $E_2$) identisch zum Abstand ($\vec{d}_{WB}$) zwischen dem Bearbeitungswerkzeug (B) und dem Ausrichtsensor (W) gewählt wird.

10. Verfahren nach Anspruch 7, **dadurch gekennzeichnet, dass** zur Bestimmung der Relativposition zwischen dem ersten und dem zweiten Objekt (O1, O2) wahlweise nur eine der beiden Abtasteinheiten ($E_1$, $E_2$) aktiviert wird.

11. Verfahren nach mindestens einem der Ansprüche 7 - 10, **dadurch gekennzeichnet, dass**

- in einem Verfahrensschritt die Objekt-Ausrichtmarkierung ($M_1$) mit dem Bearbeitungswerkzeug (B) angefahren wird und die dabei mittels einer ersten Abtasteinheit ($E_1$) erfasste Relativposition zwischen dem ersten und zweiten Objekt (O1, O2) registriert wird,
- in einem weiteren Verfahrensschritt die Objekt-Ausrichtmarkierung ($M_1$) mit dem Ausrichtsensor (W) angefahren wird und die dabei mittels einer zweiten Abtasteinheit ($E_2$) erfasste Relativposition zwischen dem ersten und zweiten Objekt (O1, O2) registriert wird,
- in einem weiteren Verfahrensschritt die Werkstück-Ausrichtmarkierung ($M_2$) mit dem Ausrichtsensor (W) angefahren wird und die dabei mittels der zweiten Abtasteinheit ($E_2$) erfasste Relativposition zwischen dem ersten und zweiten Objekt (O1, O2) registriert wird, wobei
- die Reihenfolge der drei verschiedenen Verfahrensschritte beliebig wählbar ist.

12. Verfahren nach Anspruch 11, **dadurch gekennzeichnet, dass** anschließend auf Grundlage der Messungen der vorhergehenden drei Verfahrensschritte die Positionierung des ersten Objektes (O1) gegenüber dem zweiten Objekt (O2) während der Bearbeitung des Werkstückes (WS) mit dem Bearbeitungswerkzeug (B) in der Umgebung der Werkstück-Ausrichtmarkierung ($M_2$) vorgenommen wird.

**Claims**

1. Arrangement for positioning a machining tool (B) relative to a workpiece (WS), comprising

   - a first object (O1) on which an object alignment mark ($M_1$) and the workpiece (WS) are arranged, a workpiece alignment mark ($M_2$) being arranged on the workpiece (WS), and
   - a second object (O2) which is arranged to be able to move relative to the first object (O1) along at least one direction of movement (x), there being arranged on the second object (O2)

      - the machining tool (B) via which the object alignment mark ($M_1$) can be detected, and
      - an alignment sensor (W) via which the object alignment mark ($M_1$) and the workpiece alignment mark ($M_2$) can be detected, and
      - a scannable material measure (S) which extends along the at least one direction of movement (x),

   **characterized in that**

   - at least two scanning units ($E_1$, $E_2$) for scanning the material measure (S) are arranged on the first object (O1) in order thus to determine the relative position between the first and the second object (O1, O2) along the direction of movement (x), and the two scanning units ($E_1$, $E_2$) having a defined offset ($\vec{d}_E$), and
   - the offset ($\vec{d}_E$) between the two scanning units ($E_1$, $E_2$) satisfying the condition

   $$\left| \vec{d}_E - \vec{d}_{WB} \right| < 0.2 \bullet \left| \vec{d}_{WB} \right|,$$

   where

   $\vec{d}_E$ = offset between the two scanning units,
   $\vec{d}_{WB}$ = distance between the machining tool and the alignment sensor.

2. Arrangement according to Claim 1, **characterized in that** the offset ($\vec{d}_E$) between the two scanning units ($E_1$, $E_2$) is selected to be virtually identical to the distance ($\vec{d}_{WB}$) between the machining tool (B) and the alignment sensor (W).

3. Arrangement according to Claim 1, **characterized in that** the offset ($\vec{d}_E$) between the two scanning units ($E_1$, $E_2$) is selected to be identical to the distance ($\vec{d}_{WB}$) between the machining tool (B) and the alignment sensor (W).

4. Arrangement according to at least one of the preceding claims, **characterized in that** the scanning units ($E_1$, $E_2$) are designed to be selectively capable of activation in order to determine the relative position between the first and the second object (O1, O2) along the direction of movement (x).

5. Arrangement according to Claim 1, **characterized in that** the object alignment mark ($M_1$) and/or workpiece alignment mark ($M_2$) are/is designed as a microstructure(s).

6. Arrangement according to Claim 1, **characterized in that** the material measure is designed as a linear division or as an angle division or as a two-dimensional cross grating division.

7. Method for positioning a machining tool (B) relative to a workpiece (WS), in which

   - an object alignment mark ($M_1$) and the workpiece (WS) are arranged on a first object (01), and a workpiece alignment mark ($M_2$) is arranged on the workpiece (WS), and
   - a second object (02) is arranged to be able to move relative to the first object (O1) along at least one direction of movement (x), there being arranged on the second object (O2)

      - the machining tool (B) via which the object alignment mark ($M_1$) is detected, and
      - an alignment sensor (W) via which the object alignment mark ($M_1$) and the workpiece alignment mark

($M_2$) are detected, and

- a scannable material measure (S) which extends along the at least one direction of movement (x),

**characterized in that**

- at least two scanning units ($E_1$, $E_2$) for scanning the material measure (S) are arranged on the first object (01) in order thus to determine the relative position between the first and the second object (O1, O2) along the direction of movement (x), and the two scanning units ($E_1$, $E_2$) having a defined offset ($\vec{d}_E$), and
- the offset ($\vec{d}_E$) between the two scanning units ($E_1$, $E_2$) is selected according to the condition

$$\left| \vec{d}_E - \vec{d}_{WB} \right| < 0.2 \bullet \left| \vec{d}_{WB} \right|,$$

where

$\vec{d}_E$ = offset between the two scanning units,
$\vec{d}_{WB}$ = distance between the machining tool and the alignment sensor.

8.  Method according to Claim 7, **characterized in that** the offset ($\vec{d}_E$) between the two scanning units ($E_1$, $E_2$) is selected to be virtually identical to the distance ($d_{WB}$) between the machining tool (B) and the alignment sensor (W).

9.  Method according to Claim 7, **characterized in that** the offset ($\vec{d}_E$) between the two scanning units ($E_1$, $E_2$) is selected to be identical to the distance ($\vec{d}_{WB}$) between the machining tool (B) and the alignment sensor (W).

10. Method according to Claim 7, **characterized in that** one of the two scanning units ($E_1$, $E_2$) is optionally activated in order to determine the relative position between the first and the second object (O1, O2).

11. Method according to at least one of Claims 7-10, **characterized in that**

- in one method step the object alignment mark ($M_1$) is approached by the machining tool (B), and the relative position, detected in this case by means of a first scanning unit ($E_1$), between the first and second object (O1, O2) is recorded,
- in a further method step the object alignment mark ($M_1$) is approached by the alignment sensor (W) and the relative position detected in this case by means of a second scanning unit ($E_2$), between the first and second object (O1, O2) is recorded,
- in a further method step the workpiece alignment mark ($M_2$) is approached by the alignment sensor (W), and the relative position, detected in this case by means of the second scanning unit ($E_2$), between the first and second object (O1, O2) is recorded,
- the sequence of the three different method steps being arbitrarily selectable.

12. Method according to Claim 11, **characterized in that** subsequently it is undertaken on the basis of the measurements of the preceding three method steps to position the first object (O1) relative to the second object (O2) during the machining of the workpiece (WS) using the machining tool (B) in the surroundings of the workpiece alignment mark ($M_2$).

**Revendications**

1.  Arrangement de positionnement d'un outil d'usinage (B) par rapport à une pièce (WS) comprenant

- un premier objet (O1) sur lequel sont disposés un repère d'orientation d'objet ($M_1$) et la pièce (WS), un repère d'orientation de pièce ($M_2$) étant disposé sur la pièce (WS), et
- un deuxième objet (02) qui est disposé de manière mobile par rapport au premier objet (O1) le long d'au moins un sens de déplacement (x), sur le deuxième objet (02)

- étant disposé l'outil d'usinage (B) par le biais duquel peut être détecté le repère d'orientation d'objet ($M_1$), et
- étant disposé un capteur d'orientation (W) par le biais duquel peuvent être détectés le repère d'orientation d'objet ($M_1$) et le repère d'orientation de pièce ($M_2$), et
- étant disposée une mesure matérialisée (S) palpable qui s'étend le long de l'au moins un sens de déplacement (x),

**caractérisé en ce que**

- sur le premier objet (O1) sont disposées au moins deux unités de palpage ($E_1$, $E_2$) destinées à palper la mesure matérialisée (S) afin de déterminer ainsi la position relative entre le premier et le deuxième objet (O1, O2) le long du sens de déplacement (x) et les deux unités de palpage ($E_1$, $E_2$) présentant un décalage défini ($\vec{d}_E$) et
- le décalage ($\vec{d}_E$) entre les deux unités de palpage ($E_1$, $E_2$) satisfaisant à la condition

$$\left|\vec{d}_E - \vec{d}_{WB}\right| < 0{,}2 \cdot \left|\vec{d}_{WB}\right|,$$

où

$\vec{d}_E$ désigne le décalage entre les deux unités de palpage,
$\vec{d}_{WB}$ désigne l'écart entre l'outil d'usinage et le capteur d'orientation.

2. Arrangement selon la revendication 1, **caractérisé en ce que** le décalage ($\vec{d}_E$) entre les deux unités de palpage ($E_1$, $E_2$) est choisi quasiment identique à l'écart ($\vec{d}_{WB}$) entre l'outil d'usinage (B) et le capteur d'orientation (W).

3. Arrangement selon la revendication 1, **caractérisé en ce que** le décalage ($\vec{d}_E$) entre les deux unités de palpage ($E_1$, $E_2$) est choisi identique à l'écart ($\vec{d}_{WB}$) entre l'outil d'usinage (B) et le capteur d'orientation (W).

4. Arrangement selon au moins l'une des revendications précédentes, **caractérisé en ce que** pour déterminer la position relative entre le premier et le deuxième objet (O1, O2) le long du sens de déplacement (x), les unités de palpage ($E_1$, $E_2$) sont configurées pour pouvoir être activées de manière sélective.

5. Arrangement selon la revendication 1, **caractérisé en ce que** le repère d'orientation d'objet ($M_1$) et/ou le repère d'orientation de pièce ($M_2$) sont réalisés sous forme de microstructure.

6. Arrangement selon la revendication 1, **caractérisé en ce que** la mesure matérialisée est réalisée sous la forme d'une division linéaire ou d'une division angulaire ou d'une division de grille bidimensionnelle.

7. Procédé de positionnement d'un outil d'usinage (B) par rapport à une pièce (WS), selon lequel

- un repère d'orientation d'objet ($M_1$) et la pièce (WS) sont disposés sur un premier objet (01) et un repère d'orientation de pièce ($M_2$) est disposé sur la pièce (WS), et
- un deuxième objet (02) est disposé de manière mobile par rapport au premier objet (01) le long d'au moins un sens de déplacement (x), sur le deuxième objet (02)

- étant disposé l'outil d'usinage (B) par le biais duquel est détecté le repère d'orientation d'objet ($M_1$), et
- étant disposé un capteur d'orientation (W) par le biais duquel peuvent être détectés le repère d'orientation d'objet ($M_1$) et le repère d'orientation de pièce ($M_2$), et
- étant disposée une mesure matérialisée (S) palpable qui s'étend le long de l'au moins un sens de déplacement (x),

**caractérisé en ce que**

- sur le premier objet (O1) sont disposées au moins deux unités de palpage ($E_1$, $E_2$) destinées à palper la mesure matérialisée (S), par le biais desquelles est déterminée la position relative entre le premier et le deuxième objet (O1, O2) le long du sens de déplacement (x) et les deux unités de palpage ($E_1$, $E_2$) présentant un décalage

défini ($\vec{d}_E$) et

- le décalage ($\vec{d}_E$) entre les deux unités de palpage (E$_1$, E$_2$) étant choisi conformément à la condition

$$\left| \vec{d}_E - \vec{d}_{WE} \right| < 0{,}2 \cdot \left| \vec{d}_{WB} \right|,$$

où

$\vec{d}_E$ désigne le décalage entre les deux unités de palpage,
$\vec{d}_{WE}$ désigne l'écart entre l'outil d' usinage et le capteur d'orientation.

8. Procédé selon la revendication 7, **caractérisé en ce que** le décalage ($\vec{d}_E$) entre les deux unités de palpage (E$_1$, E$_2$) est choisi quasiment identique à l'écart ($\vec{d}_{WB}$) entre l'outil d'usinage (B) et le capteur d'orientation (W).

9. Procédé selon à revendication 7, **caractérisé en ce que** le décalage ($\vec{d}_E$) entre les deux unités de palpage (E$_1$, E$_2$) est choisi identique à l'écart ($\vec{d}_{WB}$) entre l'outil d'usinage (B) et le capteur d'orientation (W).

10. Procédé selon la revendication 7, **caractérisé en ce que** pour déterminer la position relative entre le premier et le deuxième objet (O1, O2), une seule des deux unités de palpage (E$_1$, E$_2$) est activée, au choix.

11. Procédé selon au moins l'une des revendications 7 à 10, **caractérisé en ce que**

- dans une étape du procédé, l'outil d'usinage (B) est déplacé jusqu'au repère d'orientation d'objet (M$_1$) et la position relative entre le premier et le deuxième objet (O1, O2) ainsi détectée au moyen d'une première unité de palpage (E$_1$) est enregistrée,
- dans une étape supplémentaire du procédé, le capteur d'orientation (W) est déplacé jusqu'au repère d'orientation d'objet (M$_1$) et la position relative entre le premier et le deuxième objet (O1, O2) ainsi détectée au moyen d'une deuxième unité de palpage (E$_2$) est enregistrée,
- dans une étape supplémentaire du procédé, le capteur d'orientation (W) est déplacé jusqu'au repère d'orientation de pièce (M$_2$) et la position relative entre le premier et le deuxième objet (O1, O2) ainsi détectée au moyen de la deuxième unité de palpage (E$_2$) est enregistrée,
- l'ordre des trois étapes différentes du procédé pouvant être choisi à volonté.

12. Procédé selon la revendication 11, **caractérisé en ce que** le positionnement du premier objet (O1) par rapport au deuxième objet (O2) est ensuite réalisé, en se basant sur les mesures des trois étapes précédentes du procédé, pendant l'usinage de la pièce (WS) avec l'outil d'usinage (B) dans l'environnement du repère d'orientation de pièce (M$_2$).

Fig. 1   STAND DER TECHNIK

Fig. 2

W über M₁

W über M₂

B über M₂

B über M₁

Fig. 3

Fig. 4

Fig. 5

Fig. 6

Fig. 7

Fig. 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102007023300 A1
- US 201010220183 A1
- US 20100139836 A1